# EUROPEAN PATENT APPLICATION

(11) **EP 1 231 293 A2**
(43) Date of publication of application: **14.08.2002**
(21) Application number: 02250926.9
(22) Date of filing: 11.02.2002
(51) Int. Cl.: C23C 16/18

(54) **Method of rapid chemical vapor deposition of copper metal thin films**

(30) Priority: 13.02.2001 US 783812
(71) Applicant: Sharp Kabushiki Kaisha, Osaka-shi, Osaka 545-8522 (JP)
(72) Inventor: Zhuang, Wei Wei, Vancouver, WA 98683 (US); Evans, David Russell, Beaverton, OR 97007 (US); Hsu, Sheng Teng, Camas, WA 98607 (US)
(74) Representative: West, Alan Harry

(57) **Abstract**

A method is provided for rapid chemical vapor deposition of copper thin films, including vaporizing a first copper precursor at a first temperature; vaporizing a second copper precursor at a second temperature; introducing vapors from the first and second precursors into a chemical vapor deposition chamber, and depositing a copper metal thin film on a substrate.

## Description

This invention relates to the rapid chemical vapor deposition of copper metal thin films, and specifically to a method of rapid chemical vapor deposition (CVD) of copper metal thin films using two different organometallic copper precursors.

There is a need to mass produce copper metal thin films for applications in the electronic industry. The prior art contains reports of various methods of copper metal thin film deposition, including the use of various copper precursors, such as Cu(C₅H₅)(PR₃), where R = methyl, ethyl, or butyl, as disclosed by Beach et al., in Chem. Mater. 1990, Vol. 2, pp 216-219; Cu(hfac)(CH₃C=CCH₃), where hfac = hexafluoroacetylacetonate, as disclosed by Baum et al., J. Electrochem. Soc. 1993, Vol. 140, No. 1., 154-158; and Cu(hfac)(TMVS), where TMVS = trimethylvinylsilane, as disclosed by Norman et al. Journal de Physique IV, September 1991, Vol. 1., C2-271-278; and using different CVD tools. The foregoing have reported the deposition of pure copper thin films in laboratory processes.

To mass produce copper thin films, however, the laboratory methods need to be refined and made suitable for commercial production. For instance, Cu(C₅H₅)(PR₃) is not a good source for commercial copper CVD processing because the carbon and phosphorus contaminate the copper thin film. Additionally, the cost of Cu(hfac)(TMVS) and Cu(hfac)(alkene) precursors is prohibitively high. Further, none of the known processes provide a rapid CVD of pure, contaminate-free, copper. In the prior art, rapid deposition of copper thin films is achieved using a variety of copper precursors; however, the deposited copper thin films have poor adhesive qualities when applied to metal and/or metal nitride substrates, and such prior art rapid deposition may result in an unacceptably high resistance.

The invention seeks to provide a method for the mass production of CVD copper metal thin films for IC device applications, in which the copper thin films exhibit superior adhesive properties to metal and metal nitride substrates and in which the copper thin films exhibit low resistivity.

In accordance with the invention, there is provided a method of rapid chemical vapor deposition of copper thin films, including vaporizing a first copper precursor at a first temperature; vaporizing a second copper precursor at a second temperature; introducing vapors from the first and second precursors into a chemical vapor deposition chamber; and depositing a copper metal thin film on a substrate.

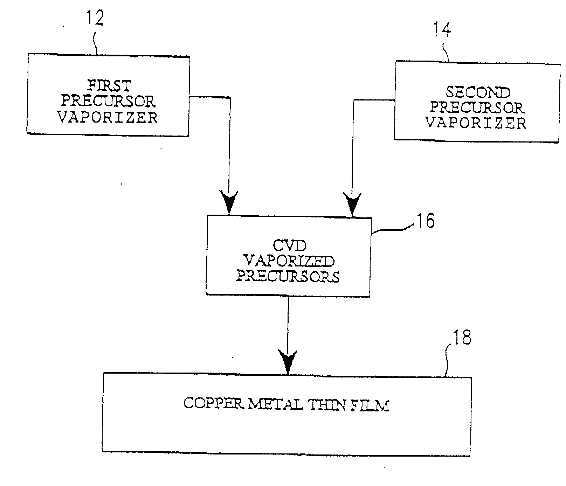

The invention is described below in greater detail by way of example only with reference to the accompanying drawing, which is a block diagram depicting the method of the invention.

The method of the invention permits the achievement of a fast deposition rate while providing high quality copper thin films having relatively low resistivity. Thus, the method of the invention is suitable for the mass production of copper thin films.

To mass produce copper metal thin films by chemical vapor deposition (CVD), the copper metal thin film deposition rate must be sufficiently high, and the metal thin film properties must be maintained. As described in the prior art, the deposition rate must be sufficiently low to provide the desired adhesive properties, and the deposition rate is limited by using CupraSelect (Cu(hfac)(TMVS)) as copper thin film source. The use of the copper precursors described herein provides a choice of different copper thin film deposition sources. All of the copper precursors described herein may be used as sources for chemical vapor deposition of pure copper metal thin films having low resistivity. Other properties of copper metal thin films deposited using the copper precursors of the invention vary depending on the individual precursor.

Some precursors, having stabilizer ligand high boiling points. i.e. above 165°C and up to about 175°C, such as (α-methylstyrene)Cu(hfac) and (1-decene)Cu(hfac), where hfac = hexafluoroacethylacetonate, produce copper thin films with excellent adhesive properties, which vigorously adhere to metal and metal nitride substrates. Precursors with stabilizer ligand low boiling points, i.e., between about 30°C and 65°C, such as (1-hexene)Cu(hfac) (63°C), (1-pentene)Cu(hfac) (-30°C) and (3,3-dimethyl-1-butene)Cu(hfac) (-43°C to 45°C), are extremely volatile, providing a very high deposition rate, which may be obtained without the use of excessive energy to vaporize the precursor.

Two kinds of precursors may be used to achieve the rapid deposition of copper metal thin films. The first type of precursor, including (α-methylstyrene)Cu(hfac) and (1-decene)Cu(hfac), may be used to deposit an extremely thin layer of copper metal in a short time because of its excellent adhesive properties on metal and metal nitride substrates. The second type of precursor, including (1-hexene)Cu(hfac), (1-pentene)Cu(hfac) and (3,3-dimethyl-1-butene)Cu(hfac), may be used for the rapid deposition of copper metal thin films because of their high volatility. The deposition of the first type of copper precursor will require less than thirty seconds of CVD to deposit a copper metal thin film having a thickness of about 300Å. A 5000Å thick copper metal thin film may be deposited using the second type of copper precursor in less than five minutes. Use of either precursor type results in a copper thin film having excellent adhesion to metal and metal nitride substrates, and also having relatively low resistivity.

The use of two different copper precursors for CVD of pure copper thin films requires the use of two vaporizers on a CVD reactor, as shown generally in the accompanying drawing. To achieve the deposition of a copper seed layer, in a short time, such as by using (α-methylstyrene)Cu(hfac), the temperature of a first precursor vaporizer 12 should be increased to between about 60°C to 80°C, and preferably closer to 80°C, and for the fast deposition of copper thin films, such as by using (1-pentene)Cu(hfac), the temperature of a second precursor vaporizer 14 should be maintained at a lower temperature, of between about 45°C to 60°C, and preferably about 55°C. The deposition parameters for two types of copper precursors may easily be controlled by computers, as the vaporized precursors are fed in a CVD chamber 16, resulting in a copper thin film 18 having the desired physical and chemical properties.

One method of the invention uses (α-methylstyrene)Cu(hfac) as the copper seed thin film deposition, because of its extremely high adhesive properties to metal and metal nitride substrates. Copper thin films deposited by using (α-methylstyrene)Cu(hfac) also exhibit low resistivities. The fast deposition precursor may be selected from among several excellent choices, such as (1-pentene)Cu(hfac), (1-hexene)Cu(hfac), and (3,3-dimethyl-1-butene)Cu(hfac) etc. All of the copper precursors identified as first or second type precursors are much less expensive than (TMVS)Cu(hfac). Thus, the mass production of copper thin film deposition may be accomplished by the method of the invention.

## Claims

1. A method of rapid chemical vapor deposition of copper thin films, comprising:
vaporizing (12) a first copper precursor at a first temperature;
vaporizing (14) a second copper precursor at a second temperature;
introducing (16) vapors from the first and second precursors into a chemical vapor deposition chamber, and
depositing a copper metal thin film (18) on a substrate.

2. A method according to claim 1, wherein the first copper precursor includes stabilizer ligands having a boiling point between 165 and 175°C.

3. A method according to claim 1 or claim 2, wherein the first copper precursor is selected from (α-methylstyrene)Cu(hfac) and (1-decene)Cu(hfac), where hfac = hexafluoroacetylacetonate.

4. A method according to any one of claims 1 to 3, wherein the first copper precursor is vaporized at a temperature between 60 and 80°C.

5. A method according to any one of claims 1 to 4, wherein the second copper precursor includes stabilizer ligands having a boiling point between 30 and 65°C.

6. A method according to any one of claims 1 to 5, wherein the second copper precursor is selected from (1-pentene)Cu(hfac), (1-hexene)Cu(hfac), and (3,3-dimethyl-1-butene)Cu(hfac), where hfac = hexafluoroacetylacetonate.

7. A method according to any one of claims 1 to 6, wherein the second copper precursor is vaporized at a temperature between 45 and 60°C.
